# EUROPEAN PATENT APPLICATION

(11) **EP 1 744 462 A1**
(43) Date of publication of application: **17.01.2007**
(21) Application number: 06712569.0
(22) Date of filing: 30.01.2006
(51) Int. Cl.: H04B 1/10, H03B 5/12

(54) **VCO DEVICE, AND TUNER, BROADCAST RECEIVER AND MOBILE TELEPHONE USING THE DEVICE**

(30) Priority: 07.02.2005 JP 2005030071
(71) Applicant: MATSUSHITA ELECTRIC INDUSTRIAL CO., LTD., Osaka 571-8501 (JP)
(72) Inventor: OZEKI, Hiroaki, Matsushita Electr. Ind.Co.,Ltd, Chuo-ku, Osaka-shi, Osaka 540-6319 (JP); FUJII, Takeshi, Matsushita Electr. Ind.Co.,Ltd, Chuo-ku, Osaka-shi, Osaka 540-6319 (JP); IWADA, Mineyuki, Matsushita Electr. Ind.Co.,Ltd, Chuo-ku, Osaka-shi, Osaka 540-6319 (JP)
(74) Representative: Grünecker, Kinkeldey, Stockmair & Schwanhäusser Anwaltssozietät
(86) International application number: PCT/JP2006/001426
(87) International publication number: WO 2006/082775

(57) **Abstract**

It is intended to provide a VCO apparatus having: a local oscillation signal generation circuit for outputting a local oscillation signal corresponding to a frequency signal of a tuned channel to be received, the frequency signal being included in high frequency signals received by an input terminal, and a mixing circuit for outputting a baseband signal by mixing the high frequency signal and the local oscillation signal, wherein the local oscillation signal generation circuit has an oscillator for oscillating the local oscillation signal and a frequency reduction unit for outputting a frequency of the local oscillation signal oscillated by the oscillator to the mixing circuit at a ratio of ×1/N, and the local oscillation signal frequency is set to a frequency different from a communication wireless frequency used by a mobile phone by adjusting the ratio of ×1/N.

## Description

### Technical Field

This invention relates to a broadband VCO (Voltage Controlled Oscillator) apparatus to be mounted on a broadcasting receiver, and, particularly, to the VCO apparatus and a tuner to be incorporated into a mobile wireless appliance such as a mobile phone handling wireless transmission/reception signals other than a broadcasting radio wave.

### Related Art

Recently, multifunctionalization of mobile wireless appliances has been developed. For instance, as an additional function of a mobile phone, it is possible to watch an image displayed on a liquid display screen of the mobile phone by receiving TV radio signals.

In the case of adding a tuner using a different wireless frequency band such as the TV radio signal to the mobile wireless appliance, there is a problem of deterioration in signal quality due to mutual interference of the wireless signals between the mobile wireless appliance and the tuner.

For instance, when the tuner incorporated into the mobile wireless appliance operates to receive a TV image, the quality deterioration occurs in an internet information distribution function, an e-mail function, or the like of the mobile wireless appliance that operates simultaneously. In such case, adverse influences such as unnecessarily long communication time and quality deterioration in voice in phone call are caused.

Also, in the case of using the mobile wireless appliance in a car or a train, the mobile wireless appliance sometimes transmits a radio wave having high field intensity. In such case, quality deterioration is caused in received images and voices of TV radio wave, which are sequentially viewed and heard, to sometimes hinder the TV-watching for a moment.

Conventionally, in the mobile phone having the additional function of receiving TV radio wave, operation of watching TV radio wave is prevented from being performed simultaneously with the operation of phone call or data communication which is the major function in order to avoid the wireless signal interference, and a system of performing either one of the operations alone has been used. Also, since the analog broadcasting which is relatively inferior in clarity of image and voice signals has been employed for the TV radio wave, the momentary quality deterioration in received image and voice caused by the radio wave having high field intensity transmitted from the mobile wireless appliance has not resulted in marked discomfort.

The conventional technology is disclosed in Japanese Patent Unexamined Publication No. 2004-96218, for example.

However, since it is possible to clearly reproduce an image and voice to view and hear in the case of receiving a digital broadcasting which is to be the major broadcasting system due to the future change in TV broadcasting system, the deterioration in signal quality involved in the above-mentioned situation will become evident.

### Disclosure of the Invention

In order to solve the above-described problem, a VCO apparatus according to this invention has a local oscillation signal generation circuit for outputting a local oscillation signal corresponding to a frequency signal of a tuned channel to be received, the frequency signal being included in high frequency signals received by an input terminal, and a mixing circuit for outputting a baseband signal by mixing the high frequency signal and the local oscillation signal. The local oscillation signal generation circuit has an oscillator for oscillating the local oscillation signal and a frequency reduction unit for outputting a frequency of the local oscillation signal oscillated by the oscillator to the mixing circuit at a ratio of ×1/N. By adjusting the ratio of ×1/N, the local oscillation signal frequency and a communication wireless frequency to be used by a mobile phone are so set as to avoid direct overlapping with each other.

With such constitution, since it is possible to maintain the local oscillation signal outputted from the VCO apparatus incorporated into a tuner to a frequency band which is different from transmission and reception frequencies of a mobile wireless appliance, it is possible to prevent interference of the wireless frequencies also in the case where the tuner and the mobile wireless appliance operate simultaneously, thereby enhancing signal qualities of the tuner and the mobile wireless appliance.

### Brief Description of the Drawings

Fig. 1 is a block diagram showing a mobile phone with TV function which is one example of mobile wireless appliances.
Fig. 2 is a diagram showing an oscillator of a VCO apparatus according to one embodiment of this invention.
Fig. 3 is a diagram showing a constitution of a frequency reduction unit according to one embodiment of this invention.
Fig. 4A is a diagram showing local oscillation frequencies of the VCO apparatus according to one embodiment of this invention.
Fig. 4B is a diagram showing a relationship between the local oscillation frequencies of the VCO apparatus and frequencies of wireless signals used in a mobile phone incorporating a television broadcasting receiver tuner according to one embodiment of this invention.

### Description of Reference Numerals

- 1:: telephone function block
- 2:: television function block
- 3:: arithmetic processing block
- 4:: speaker unit
- 5:: microphone unit
- 6:: key operation unit
- 7:: monitor unit
- 8:: antenna device of mobile phone
- 9:: duplexer
- 10:: transmitting circuit block
- 11:: receiving circuit block
- 12:: antenna device of tuner
- 13:: tuner block
- 16:: mixer of tuner
- 17:: local oscillation unit of tuner
- 170:: oscillator
- 171, 172, 173:: VCO
- 1700:: frequency reduction unit
- 1701, 1702, 1703:: frequency divider
- 1711, 1712, 1713, 1714:: signal switching unit
- 18:: tuning unit
- 19:: VCO selection unit
- 20:: frequency dividing ratio selection unit
- 25:: leakage path of transmission wireless signal of mobile phone
- 26:: leakage path of local oscillation signal of tuner
- 31, 32, 33, 34, 35, 36:: terminal
- 101, 102:: logic element
- 201:: first switching element
- 202:: second switching element
- 203:: third switching element
- 204:: fourth switching element
- 205:: fifth switching element
- 301:: first inductance element
- 311:: second inductance element
- 302, 303, 304, 305, 313, 314, 315, 316:: capacitive element
- 306, 312:: variable capacitive element
- 401, 402:: transistor

### Best Mode for Carrying out the Invention

Hereinafter, embodiments of this invention will be described with reference to the drawings.

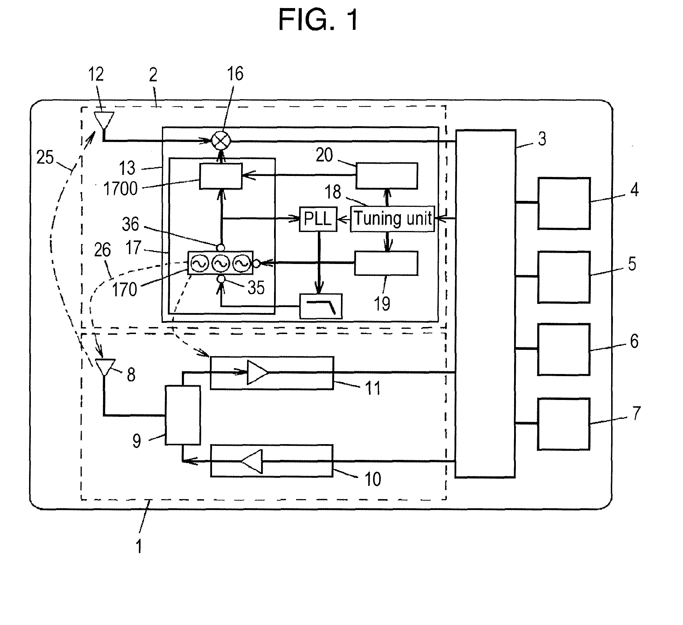

Fig. 1 is a block diagram showing a mobile phone with TV function which is one example of mobile wireless appliances. Referring to Fig. 1, the mobile phone has telephone function block 1, television function block 2, arithmetic processing block 3, speaker unit 4, microphone unit 5, key operation unit 6, and monitor unit 7.

Telephone function block 1 has mobile phone antenna device 8, duplexer 9, receiving circuit block 11, and transmitting circuit block 10. Mobile pone antenna device 8 receives and transmits signals. Duplexer 9 is positioned at a rear stage of mobile phone antenna device 8 to sort out the transmitted/received signals. Receiving circuit block 11 is positioned at a rear stage of a reception side in duplexer 9 to process the received signal in a high frequency region. Transmitting circuit block 10 is positioned at a rear stage of a transmission side in duplexer 9 to process the transmission signal in a high frequency region.

Television function block 2 has tuner antenna device 12 and tuner block 13. Tuner antenna device 12 receives a TV signal. Tuner block 13 is positioned at a rear stage of tuner antenna device 12.

Leakage path 25 of a transmission wireless signal of the mobile phone is a path from mobile phone antenna device 8 to tuner antenna device 12. After passing through leakage path 25, the transmission wireless signal of the mobile phone enters local oscillation unit 17 via tuner block 13 and tuner mixer 16. As a result, a local coupling is generated to deteriorate quality of the received TV signal in the case where local oscillation unit 17 performs an oscillation operation at a frequency close to that of the transmission wireless signal of the mobile phone. As a countermeasure against the signal quality deterioration, a method of damping the transmission wireless signal by inserting a filter (not shown) into a signal path between mobile phone antenna device 12 and tuner block 13 is considered. However, in actuality, since it is difficult to realize an ideal filter for damping bands other than the frequency band of TV broadcasting, signal amplitude of the TV signal itself is damped by the above method to deteriorate signal sensitivity.

Leakage path 26 of the local oscillation signal of the tuner is a path for entering mobile phone antenna device 8 or receiving circuit block 11 from local oscillation unit 17 directly from a power source line or the like in an open space or inside a substrate. In the case where a frequency outputted from the local oscillation unit 17 is close to a frequency to be received by receiving circuit block 11 of the mobile phone, the local oscillation signal of the tuner is a disturbing signal. As a result, quality of a phone call signal or a data communication signal is deteriorated in receiving circuit block 11. As countermeasures against the signal quality deterioration, there have been proposed a method of suppressing signal amplitude resonated in local oscillation unit 17 and a method of diminishing the influence by reducing amplitude of a signal to be outputted to mixer 16 of the tuner. However, when amplitude of the resonance signal is reduced, a phase noise is deteriorated to cause deficiency in oscillation gain in some cases, resulting in failure of tuning in on a TV broadcasting station. Also, the reduction in amplitude of signal to be outputted to mixer 16 of the tuner causes a deterioration of characteristic such as a gain of the mixer.

Therefore, in this embodiment, different frequencies are used in order to prevent the wireless signals used for the mobile phone function and the TV receiving function from interfering with each other in the case where the functions are operated simultaneously.

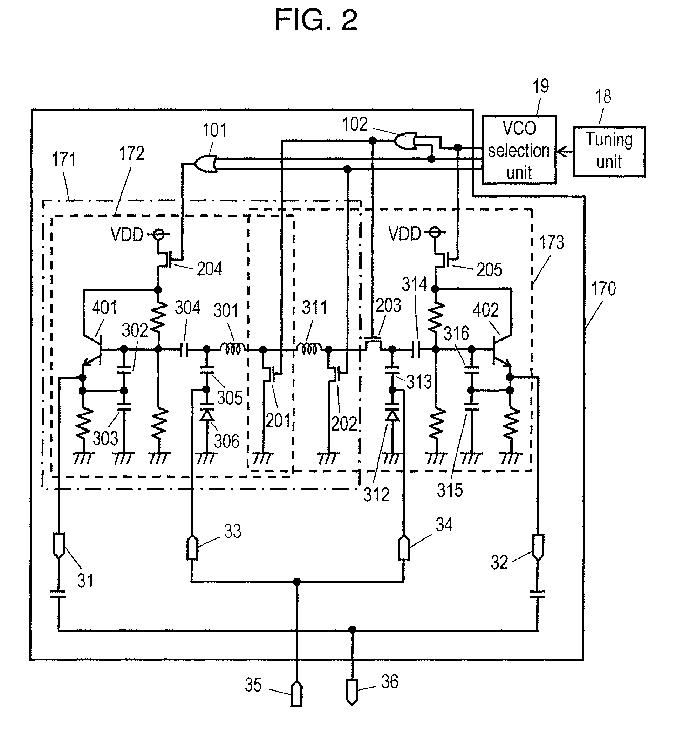

Fig. 2 is a diagram showing an oscillator of a VCO apparatus according to one embodiment of this invention. Oscillator 170 has three types of VCOs 171, 172, and 173 that oscillate frequency bands different from one another. VCO selection unit 19 selects one of the three types of VCOs 171, 172, and 173 based on frequency information outputted from tuning unit 18. A selection signal outputted from VCO selection unit 19 selectively switches among oscillation operations of the three types of VCOs 171, 172, and 173. First switching element 201, second switching element 202, third switching element 203, fourth switching element 204, and fifth switching element 205 are brought into a conduction state in positive logic. Logic elements 101 and 102 control conduction/non-conduction of first switching element 201, second switching element 202, third switching element 203, fourth switching element 204, and fifth switching element 205. The three types of VCOs 171, 172, and 173 are of the clap type that is generally known. A control voltage for controlling an oscillation frequency range is inputted from input terminal 35, and an oscillation output signal is outputted from output terminal 36.

To start with, a case wherein VCO 173 is selected will be described. A source voltage is connected to a collector of transistor 402 serving as a negative resistance element, a bias voltage obtained by dividing the resistivity of the source voltage is supplied to a base. A positive feedback of oscillation signal is established between an emitter and a base of transistor 402 via capacitive element 316. A resonance circuit is formed of inductance element 311, capacitive element 313, and variable capacitive element 312. One end of second inductance element 311 is connected to the base of transistor 402 via capacitive element 314. A resonance frequency is controlled by varying a capacitance of variable capacitive element 312 with the use of a voltage inputted from input terminal 34. An oscillation signal, i.e. a local oscillation signal, is taken out from output terminal 32 connected to the emitter of transistor 402.

In this case, first switching element 201, third switching element 203, and fifth switching element 205 are brought into the conduction state by a positive logic signal inputted thereto. As a result, transistor 402 is brought into an on-state when the source voltage is supplied thereto, and a frequency signal is oscillated by an LC resonance achieved by a synthetic capacitance of second inductance element 311, variable capacitive element 312, and capacitive elements 313 to 316 to be outputted. In turn, switching elements 202 and 204 are in the non-conduction state due to a negative logic control signal inputted thereto. Accordingly, transistor 401 is in an off state since no source voltage is applied thereto, and a different oscillation operation is not performed in an LC element formed of first inductance element 301, variable capacitive element 306, and capacitive elements 302 to 305.

Hereinafter, a case wherein VCO 172 is selected will be described. In this case, first switching element 201 and fourth switching element 204 are in the conduction state due to the positive logic signal inputted thereto. As a result, the source voltage is supplied to transistor 401 to bring transistor 401 into the on-state. A frequency signal is oscillated by an LC resonance achieved by a synthetic capacitance of inductance element 301, variable capacitive element 306, and capacitive elements 302 to 305 to be outputted. A capacitance of variable capacitive element 306 is varied with the use of a voltage inputted from input terminal 33 to control a resonance frequency. Then, an oscillation signal, i.e. a local oscillation signal, is taken out from output terminal 31 connected to an emitter of transistor 401. In turn, second switching element 202, third switching element 203, and fifth switching element 205 are in the non-conduction state due to the negative logic control signal inputted thereto. Accordingly, transistor 402 is in an off-state since no source voltage is applied thereto. Different oscillation operations are not performed in the LC element formed of second inductance element 311, variable capacitive element 312, and capacitive elements 313 to 316.

Lastly, a case wherein VCO 171 is selected will be described. In this case, the positive logic signal is inputted to second switching element 202 and fourth switching element 204 to establish the conduction state, and the negative logic control signal is inputted to first switching element 201, third switching element 203, and fifth switching element 205 to establish the non-conduction state. Transistor 401 is brought into the on state by application of the source voltage. A frequency signal is oscillated due to an LC resonance formed of synthetic inductance obtained by serially connecting and adding first inductance element 301, and second inductance element 311, and synthetic capacitance of variable capacitive element 306 and capacitive elements 302 to 306 to be outputted. The capacitance of variable capacitive element 306 is varied with the use of the voltage inputted from input terminal 33 to control a resonance frequency. Then, an oscillation signal, i.e. a local oscillation signal, is taken out from output terminal 31 connected to the emitter of transistor 401.

As described above, in the case where VCO 171 is selected, it is possible to reduce a frequency band to be oscillated by serially connecting inductance elements 301 and 311 used in VCO 172 and VCO 173. Particularly, it is possible to enhance the oscillation frequency range of the VCO apparatus without increasing the size of the circuit by adding another inductance element having a large function required by VCO 171.

Transistor 401 which is used for VCO 172 is used also as the negative resistance element for VCO 171 in the foregoing, and such usage is realized since frequency bands to be oscillated by VCOs 171 and 172 are close to each other and since a change in current to be supplied to transistor 401 is small.

When the oscillation frequency band of VCO 171 is first frequency band f1, the oscillation frequency band of VCO 172 is second frequency band f2, and the oscillation frequency band of VCO 173 is third frequency band f3, a relationship among the VCOs 171 to 173 is f1<f2<f3. In the case where a circuit configuration (not shown) capable of changing a current amount to be supplied to transistor 401 is used, the condition (f1<f2<f3) for the shared use of the transistor is not established. In the embodiment shown in Fig. 2, it is preferable to adjust the current amount of transistor 401 which is shared by VCO 171 and VCO 172 in accordance with the VCO selection situations.

The inductance used for VCO 171 is the synthetic inductance obtained by adding a parasitic inductance generated by a very short wiring serving as a signal path obtained by serially connecting first inductance element 301 and second inductance element 311. In order to improve a phase noise of the local oscillation signal to be oscillated and outputted by the VCO apparatus, it is preferable that a distance between first inductance element 301 and second inductance element 311 is made as short as possible to reduce the length of the wiring, therefore to reduce wiring series resistance Rs and parasitic capacitance Cp generated between the wiring and a ground potential as well as to increase a Q value of the synthetic inductance by reducing the wiring length.

In the case where it is necessary to further reduce the oscillation frequency band of VCO 171, another inductance element not shown in Fig. 1 and having a required function is inserted serially into the signal path between first inductance element 301 and first switching element 201, and another switching element selected by the control signal outputted from logic element 102 and not shown in Fig. 1 is inserted between the signal path connecting first inductance element 301 to the new inductance element and the ground potential.

Though the clap type is used as the structure of the oscillator of the VCO apparatus according to the foregoing embodiment of this invention, it is possible to realize the VCO apparatus using other structure such as a colpitts type or a differential type. Also, though the negative resistance transistor, the MOS-FET serving as the switching element, the varicap diode serving as the variable capacitive element are used as the circuit elements in the foregoing, it is possible to realize the VCO apparatus by using substitute devices to be used in place of the above-described devices.

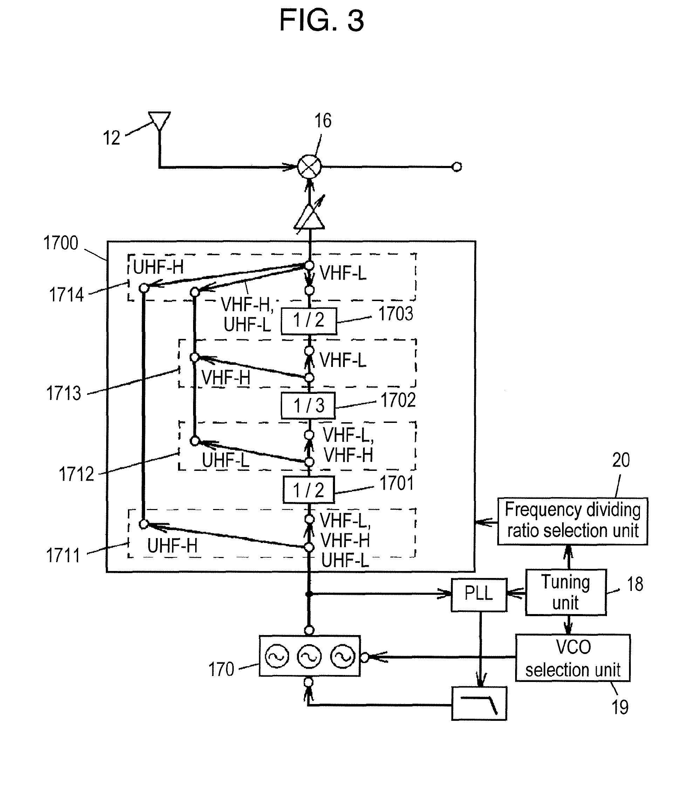

Fig. 3 is a diagram showing a frequency reduction unit according to one embodiment of this invention.

Frequency reduction unit 1700 is formed of 1/2 frequency dividers 1701 and 1703, 1/3 frequency divider 1702, and signal switching units 1711 to 1714.

Hereinafter, an operation of the frequency reduction unit according to one embodiment of this invention will be described.

Signal switching units 1711 to 1714 switches signal paths connecting oscillator 170, frequency dividers 1701 to 1703, and mixer 16 by an output signal of frequency dividing ratio selection unit 20 which sets a frequency ratio N based on frequency information outputted from tuning unit 18.

In the embodiment of the frequency reduction unit to be described hereinafter, a high frequency signal to be received by television function block 2 is set to all the channels of the ground-based broadcasting in Japan (ch1 to ch62, i.e. 93 MHz to 767 MHz). Frequency reduction unit 1700 switches among the signal paths and varies the frequency ratios N depending on four types of frequency bands obtained by sorting out the channels, namely VHF-L (ch1 to ch3, i.e. 93 MHz to 105 MHz), VHF-H (ch4 to ch12, i.e. 173 MHz to 219 MHz), UHF-L (ch13 to ch51, i.e. 473 MHz to 701 MHz), and UHF-H (ch52 to ch62, i.e. 707 MHz to 767 MHz).

Details of the frequency dividing operation performed by frequency reduction unit 1700 will be described below.

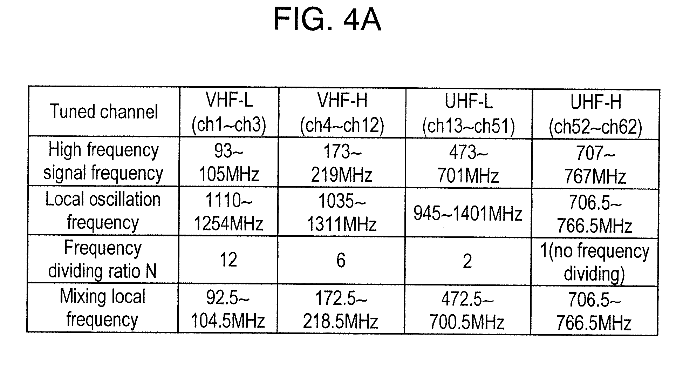

Fig. 4A is a diagram showing local oscillation frequencies of the VCO apparatus according to one embodiment of this invention. In Fig. 4A, local oscillation frequencies outputted from oscillator 170 and mixing local frequencies to be outputted to mixer 16 after multiplying the local oscillation frequencies inputted to frequency reduction unit 1700 based on the frequency dividing ratio N are shown.

In the case where VHF-L is selected as a broadcasting channel to be tuned by television function block 2, the frequency dividing ratio N is set to 12 in frequency selection unit 20. Then, one of the paths of signal switching units 1711 to 1714 is selected by a control signal outputted responsive to the frequency dividing ratio N (=12) from frequency ratio selection unit 20. In this case, the frequency dividing processing is performed via a path of oscillator 170, frequency divider 1701 (1/2), frequency divider 1702 (1/3), frequency divider 1703 (1/2), and mixer 16 in this order. As a result, a local oscillation frequency signal outputted from oscillator 170 is divided into 12 components (1/2 × 1/3 × 1/2). The signal divided into 12 components is inputted to mixer 16 as a mixing local frequency signal. In mixer 16, the mixing local frequency signal and the high frequency signal inputted from antenna device 12 are mixed so that a baseband signal is outputted. In one embodiment of this invention, due to a relationship among the frequencies when receiving VHF-L as shown in Fig. 4A, the baseband signal is outputted as 500 kHz. The relationship between the frequencies in the VHF-L selection is as follows: high frequency signal frequency = 93 MHz to 105 MHz; local oscillation frequency = 1110 MHz to 1254 MHz; and mixing local frequency = 92.5 MHz to 104.5 MHz.

In the case where VHF-H is selected as a broadcasting channel to be tuned by television function block 2, the frequency dividing ratio N is set to 6 in frequency selection unit 20. Then, one of the paths of signal switching units 1711 to 1714 is selected by a control signal outputted responsive to the frequency dividing ratio N (=6) from frequency ratio selection unit 20. In this case, the frequency dividing processing is performed via a path of oscillator 170, frequency divider 1701 (1/2), frequency divider 1702 (1/3), and mixer 16 in this order. As a result, a local oscillation frequency signal outputted from oscillator 170 is divided into 6 components (1/2 × 1/3). The signal divided into 6 components is inputted to mixer 16 as a mixing local frequency signal. In mixer 16, the mixing local frequency signal and the high frequency signal inputted from antenna device 12 are mixed so that a baseband signal is outputted. In one embodiment of this invention, due to a relationship among the frequencies when receiving VHF-H as shown in Fig. 4A, the baseband signal is outputted as 500 kHz. The relationship between the frequencies in the VHF-H selection is as follows: high frequency signal frequency = 173 MHz to 219 MHz; local oscillation frequency = 1035 MHz to 1311 MHz; and mixing local frequency = 172.5 MHz to 218.5 MHz.

In the case where UHF-L is selected as a broadcasting channel to be tuned by television function block 2, the frequency dividing ratio N is set to 2 in frequency selection unit 20. Then, one of the paths of signal switching units 1711 to 1714 is selected by a control signal outputted responsive to the frequency dividing ratio N (=2) from frequency ratio selection unit 20. In this case, the frequency dividing processing is performed via a path of oscillator 170, frequency divider 1701 (1/2), and mixer 16 in this order. As a result, a local oscillation frequency signal outputted from oscillator 170 is divided into 2 components. The signal divided into 2 components is inputted to mixer 16 as a mixing local frequency signal. In mixer 16, the mixing local frequency signal and the high frequency signal inputted from antenna device 12 are mixed so that a baseband signal is outputted. In one embodiment of this invention, due to a relationship among the frequencies when receiving VHF-H as shown in Fig. 4A, the baseband signal is outputted as 500 kHz. The relationship between the frequencies in the UHF-L selection is as follows: high frequency signal frequency = 473 MHz to 701 MHz; local oscillation frequency = 945 MHz to 1401 MHz; and mixing local frequency = 472.5 MHz to 700.5 MHz.

In the case where UHF-H is selected as a broadcasting channel to be tuned by television function block 2, the frequency dividing ratio N is set to 1 in frequency selection unit 20. Then, one of the paths of signal switching units 1711 to 1714 is selected by a control signal outputted responsive to the frequency dividing ratio N (=1) from frequency ratio selection unit 20. In this case, frequency dividing processing is not performed, and a frequency signal generated from oscillator 170 is directly inputted to mixer 16 as a mixing local frequency signal. In the case of the UHF-L selection, high frequency signal frequency = 707 MHz to 767 MHz, and local oscillation frequency = mixing local frequency = 706.5 MHz to 766.5 MHz.

It is possible to realize the 1/2 frequency dividing circuit used for frequency dividers 1701 and 1703 with the use of a circuit configuration which utilizes a known flip-flop and not shown. It is possible to realize the 1/3 frequency dividing circuit used for frequency divider 1702 with the use of a circuit configuration disclosed in Japanese Patent Unexamined publication No. 2002-314404.

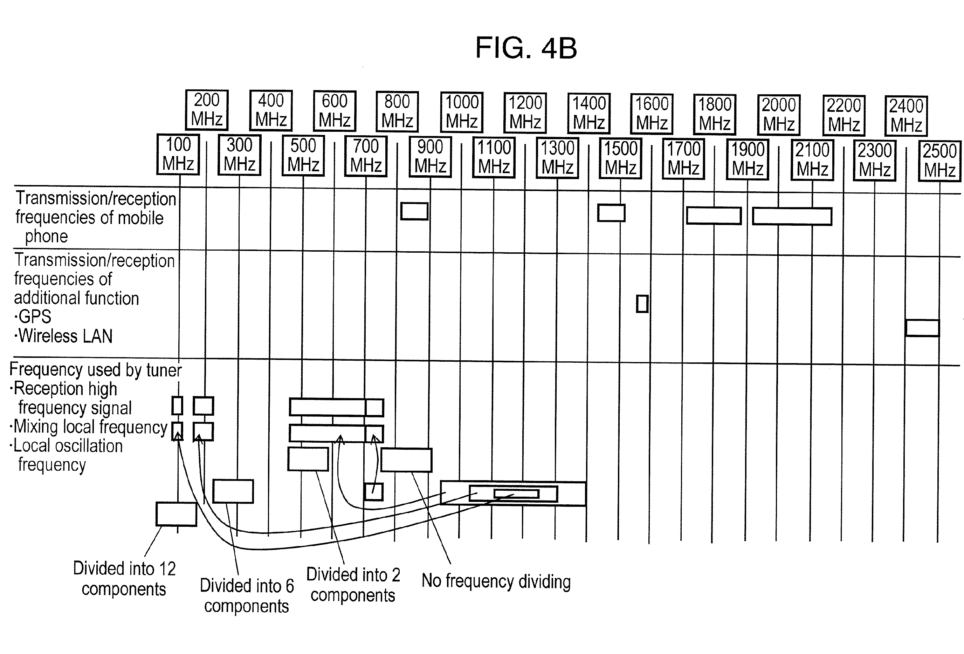

Fig. 4B is a diagram showing a relationship between the local oscillation frequency of the VCO apparatus according to one embodiment of this invention and a frequency of a wireless signal used by a mobile phone incorporating a television broadcasting receiver tuner. More specifically, shown in Fig. 4B are distributions of transmission/reception frequencies of the mobile phone, a reception frequency of GPS (Global Positioning System) which is a generally known additional wireless function of mobile phones, frequencies used for components other than the tuner, such as transmission/reception frequencies of wireless frequency of a wireless LAN (Local Area Network), a frequency of reception high frequency signal used by the tuner, a local oscillation frequency, and a mixing local frequency for mixing the reception high frequency signal with a baseband signal.

As the transmission/reception frequencies of the mobile phone, 800 to 900 MHz band which is a wireless frequency of transmission in accordance with the third generation W-CDMA (Wideband Code Division Multiple Access) standard to be used generally by mobile phones in Japan, 1.4 to 1.5 GHz band, 1.7 to 1.9 GHz band, and 1.9 to 2.2 GHz band are shown. Also, 1.5 to 1.6 GHz band which is the reception wireless frequency of GPS generally incorporated into mobile phones as an additional function and 2.4 to 2.5 GHz band which is the transmission/reception frequency of the wireless LAN (Local Area Network) are shown.

By maintaining the above-described frequency relationship, the mobile phone incorporating the domestic ground-based broadcasting receiver tuner is in accordance with the third generation W-CDMA standard, and the local oscillation frequency of the tuner does not overlap with the wireless frequencies to be used by the mobile phone and the additional wireless function even if the wireless function such as GPS and the wireless LAN are incorporated into the mobile phone as the additional function. Therefore, signal quality is not deteriorated due to mutual frequency interference otherwise caused.

In one embodiment of this invention, the constitution in which the television receiver tuner is in accordance with the ground-based broadcasting in Japan and the mobile phone is in accordance with the W-CDMA standard in Japan and has the additional functions of GPS and the wireless LAN, is described; however, a similar effect is achieved even when transmission/reception frequencies are different from those of the foregoing embodiment, such as when the television receiver tuner is in accordance with a broadcasting standard of USA or Europe, the mobile phone is in accordance with GSM (Global System for Mobile communication) and CDMA standard of Europe or USA, and the wireless LAN of the additional wireless function is in accordance with a standard of 5 GHz band, not with 2.4 GHz band.

### Industrial Applicability

According to the VCO apparatus and the tuner using the VCO apparatus according to this invention, it is possible to prevent interference of frequency signals even when a mobile wireless appliance such as a mobile phone, for example, and a tuner incorporated in the mobile wireless appliance operate simultaneously, thereby maintaining good communication quality. Particularly, this invention is useful for the cases wherein the tuner receives the digital broadcasting.

## Claims

1. A VCO apparatus comprising:
a local oscillation signal generation circuit for outputting a local oscillation signal corresponding to a frequency signal of a tuned channel to be received, the frequency signal being included in high frequency signals received by an input terminal; and
a mixing circuit for outputting a baseband signal by mixing the high frequency signal and the local oscillation signal,
wherein the local oscillation signal generation circuit has
an oscillator for oscillating the local oscillation signal and
a frequency reduction unit for outputting a frequency of the local oscillation signal oscillated by the oscillator to the mixing circuit at a ratio of 1/N times, and
the ratio of 1/N times is adjusted so as to set the local oscillation signal frequency different from a communication wireless frequency used by a mobile phone.

2. The VCO apparatus of claim 1,
wherein the frequency reduction unit includes a plurality of frequency dividers.

3. The VCO apparatus of claim 1,
wherein the oscillator includes:
a resonance unit; and
an oscillation unit which is a negative resistance,
wherein the resonance unit and the oscillation unit generate local oscillation signals responsive to the respective frequency bands which are caused by dividing a broadband frequency band of the high frequency signal into a plurality of frequency bands, and
the local oscillation signal is directly outputted to the mixing circuit when the oscillator performs oscillation of a first frequency band.

4. The VCO apparatus of claim 3,
wherein the oscillator includes a circuit where an inductance element and a capacitive element are connected in parallel, and
the inductance elements are serially connected to form an inductance synthesizing device performing the oscillation of the first frequency band.

5. The VCO apparatus of claim 4,
wherein the inductance synthesizing device is obtainable by serially connecting a first inductance element performing a second oscillation frequency band higher than the first oscillation frequency band and a second inductance element performing a third oscillation frequency band higher than the second oscillation frequency band.

6. The VCO apparatus of claim 5,
wherein the oscillator includes:
the first inductance element;
the second inductance element;
a first switching element;
a second switching element; and
a third switching element,
wherein the first switching element is disposed between a part connecting one end of the first inductance element to one end of the second inductance element and a ground potential,
the second switching element is disposed between the other end of the second inductance element and the ground potential,
the third switching element is connected to the other end of the second inductance element, and
in the case of the oscillation in the first frequency band, the first switching element is brought into a non-conduction state, the second switching element is brought into a conduction state, and the third switching element is brought into the non-conduction state.

7. The VCO apparatus of claim 6,
wherein an inductance of the inductance synthesizing device is obtainable by adding an inductance of the first inductance element, an inductance of the second inductance element, a very small inductance proportional to a length of a wiring existing between one end of the first inductance element and one end of the second inductance element.

8. A tuner comprising:
the VCO apparatus of claim 1.

9. A broadcasting receiver comprising:
the tuner of claim 8.

10. A mobile phone comprising:
the broadcasting receiver of claim 9.
